# EUROPEAN PATENT APPLICATION

(11) **EP 2 019 573 A2**
(43) Date of publication of application: **28.01.2009**
(21) Application number: 08160813.5
(22) Date of filing: 21.07.2008
(51) Int. Cl.: H05K 3/24

(54) **Wired circuit board and producing method thereof**

(30) Priority: 26.07.2007 JP 2007194143
(71) Applicant: Nitto Denko Corporation, Ibaraki-shi, Osaka 567-8680 (JP)
(72) Inventor: Ooyabu, Yasunari, Osaka 567-8680 (JP); Thaveeprungsriporn, Visit, Osaka 567-8680 (JP); Abe, Hayato, Osaka 567-8680 (JP); Nakamura, Kazuya, Osaka 567-8680 (JP); Kamei, Katsutoshi, Osaka 567-8680 (JP); Naito, Toshiki, Osaka 567-8680 (JP)
(74) Representative: Schwabe - Sandmair - Marx

(57) **Abstract**

A wired circuit board (1) includes an insulating layer (3), a conductive pattern (4) made of copper formed on the insulating layer (3) and a covering layer (5) made of an alloy of copper and tin to cover the conductive pattern (4). An existing ratio of tin in the covering layer (5) increases in accordance with a distance from an inner surface (11) adjacent to the conductive pattern (4) toward an outer surface (12) being not adjacent to the conductive pattern (4). An atomic ratio of copper to tin in the outer surface (12) of the covering layer (5) is more than 3.

## Description

### BACKGROUND OF THE INVENTION

### Field of the Invention

The present invention relates to a wired circuit board and a producing method thereof.

### Description of the Related Art

A wired circuit board has been conventionally widely employed in the field of various electric and electronic devices. Such a wired circuit board includes an insulating base layer, a conductive pattern made of copper and formed on the insulating layer, and an insulating cover layer formed on the insulating base layer to cover the conductive pattern.

When such a wired circuit board is electrified over a long period under the circumstances of high temperature and humidity, the wired circuit board may suffer ion migration may that copper forming the conductive pattern migrates to the insulating cover layer to cause a short circuit between wires forming the conductive pattern.

In order to prevent the ion migration, therefore, there has been proposed a flexible printed wiring board obtained by forming a Sn coating on the surface of a wiring section made of copper, thereafter laminating a cover lay film and pressing the Sn coating and the cover lay film at a temperature of 160°C for 60 minutes, for example (see, e.g., Japanese Unexamined Patent No.2006-278825). In a wiring section of this flexible printed wiring board, a first layer made of Cu₃Sn in contact with the wiring section and a second layer made of Cu₁₁Sn₉ superposed on the first layer are formed by the aforementioned pressing.

### SUMMARY OF THE INVENTION

In the flexible printed wiring board according to Japanese Unexamined Patent Publication No. 2006-278825, however, ion migration in the wiring section cannot be sufficiently prevented. In the flexible printed wiring board according to Japanese Unexamined Patent Publication No. 2006-278825, further, the wiring section is discolored (corroded) due to usage under the circumstances of high temperature and humidity, whereby connectivity to electronic components and connectional durability may be deteriorated in terminal portions to be connected to the electronic components, or the cover lay film may be stripped off from wires covered with the same.

An object of the present invention is to provide a wired circuit board capable of effectively preventing ion migration of copper forming a conductive pattern and capable of effectively preventing discoloration of the conductive pattern and a producing method thereof.

A wired circuit board according to the present invention comprises an insulating layer, a conductive pattern made of copper formed on the insulating layer and a covering layer made of an alloy of copper and tin to cover the conductive pattern, wherein an existing ratio of tin in the covering layer increases in accordance with a distance from an inner surface adjacent to the conductive pattern toward an outer surface being not adjacent to the conductive pattern, and an atomic ratio of copper to tin in the outer surface of the covering layer is more than 3.

In the wired circuit board according to the present invention, it is preferable that an outermost layer having a distance of not more than 1 µm from the outer surface toward an inside of the covering layer includes Cu₄₁Sn₁₁ and/or Cu₁₀Sn₃.

In the wired circuit board according to the present invention, it is preferable that an adjacent layer having a distance of more than 1 µm and not more than 2 µm from the outer surface toward an inside of the covering layer includes an alloy having an atomic ratio of copper to tin of more than 9.

In the wired circuit board according to the present invention, it is preferable that the covering layer is obtained by heating at a temperature of not less than 300°C.

A producing method of a wired circuit board according to the present invention comprises the steps of preparing an insulating layer, forming a conductive pattern made of copper on the insulating layer, forming a tin layer to cover the conductive pattern and heating the conductive pattern and the tin layer at a temperature of not less than 300°C to form a covering layer made of an alloy of copper and tin.

According to the wired circuit board and the producing method thereof of the present invention, ion migration of copper forming the conductive pattern can be effectively prevented. Therefore, wires forming the conductive pattern can be effectively prevented from a short circuit resulting from usage over a long period, and connectional reliability can be improved.

According to the wired circuit board and the producing method thereof of the present invention, further, discoloration of the conductive pattern can be effectively prevented also in usage under the circumstances of high temperature and humidity, whereby connectivity to electronic components and connectional durability can be improved.

### BRIEF DESCRIPTION OF THE DRAWINGS

FIG. 1 is a sectional view of a wired circuit board according to an embodiment of the present invention along the widthwise direction.
FIG. 2 is an enlarged sectional view showing a wire of the wired circuit board shown in FIG. 1 along the widthwise direction.
FIG. 3 is a producing process view showing a producing method of the wired circuit board shown in FIG. 1,
   (a) showing the step of preparing a metal supporting board,
   (b) showing the step of forming an insulating base layer,
   (c) showing the step of forming a conductive pattern on the insulating base layer,
   (d) showing the step of forming a tin layer on the surface of the conductive pattern, and
   (e) showing the step of forming an insulating cover layer as well as a covering layer.

### DETAILED DESCRIPTION OF THE INVENTION

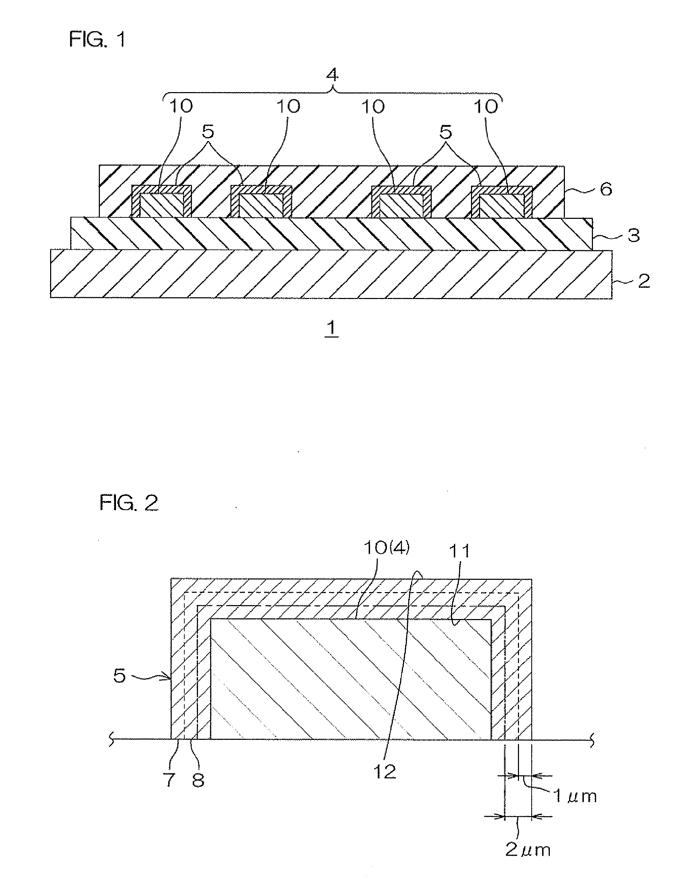

FIG. 1 is a sectional view along the widthwise direction (direction orthogonal to the longitudinal direction of the wired circuit board) of a wired circuit board according to an embodiment of the present invention, and FIG. 2 is an enlarged sectional view showing a wire of the wired circuit board shown in FIG. 1 along the widthwise direction.

Referring to FIG. 1, the wired circuit board 1 is a suspension board with circuit formed to extend in the longitudinal direction, for example, and includes a metal supporting board 2, an insulating base layer 3 formed on the metal supporting board 2 as an insulating layer and a conductive pattern 4 formed on the insulating base layer 3, for example. The wired circuit board 1 further includes a covering layer 5 covering the conductive pattern 4 and an insulating cover layer 6 formed on the insulating base layer 3 to cover the covering layer 5.

The metal supporting board 2 is formed of a flat metal foil or metal thin plate corresponding to the outer shape of the wired circuit board 1. Examples of a metal used to form the metal supporting board 2 include stainless steel and a 42-alloy, and the stainless steel is preferably used. The thickness of the metal supporting board 2 is in the range of, e.g., 15 to 30 µm, or preferably 15 to 20 µm.

The insulating base layer 3 is formed on the surface of the metal supporting board 2 to correspond to the portion where the conductive pattern 4 is formed.

Examples of an insulating material used to form the insulating base layer 5 include synthetic resin such as polyimide, polyether nitrile, polyether sulfone, polyethylene terephthalate, polyethylene naphthalate and polyvinyl chloride. Among these, a photosensitive synthetic resin is preferably used, and photosensitive polyimide is more preferably used. The thickness of the insulating base layer 3 is in the range of, e.g., 1 to 15 µm, or preferably 3 to 10 µm.

The conductive pattern 4 is formed as a wired circuit pattern including a plurality of wires 10 extending along the longitudinal direction and parallelly arranged at intervals in the widthwise direction and terminal portions (not shown) arranged on both ends of the wires 10 to be connected to a magnetic head or a read/write board.

The conductive pattern 4 is made of copper. The thickness of the conductive pattern 4 is in the range of, e.g., 5 to 20 µm, or preferably 7 to 15 µm. The width of each wire 10 is in the range of, e.g., 5 to 100 µm, or preferably 10 to 50 µm. The interval between each of the wires 10 is in the range of, e.g., 5 to 500 µm, or preferably 15 to 100 µm.

The covering layer 5 is made of an alloy of copper and tin, and formed on the side surfaces and the upper surface of the conductive pattern 4 to cover the conductive pattern 4.

More specifically, an existing ratio of tin in the covering layer 5 gradually increases from an inner surface 11 adjacent to the conductive pattern 4 toward an outer surface (the surface adjacent to the insulating cover layer 6) 12 not adjacent to the conductive pattern 4, as shown in FIG. 2.

In the outer surface 12 of this covering layer 5, the atomic ratio (Cu/Sn) of copper to tin is more than 3, preferably more than 3.3, or more preferably more than 3.7. The upper limit of the atomic ratio (Cu/Sn) of copper to tin is generally 4 in the outer surface 12 of the covering layer 5.

If the atomic ratio of copper to tin is below the aforementioned range, ion migration of copper forming the conductive pattern 4 and discoloration of the conductive pattern 4 cannot be prevented.

The thickness of the covering layer 5 is in the range of, e.g., 2 to 4 µm, or preferably 2 to 3 µm.

This covering layer 5 is formed by heating a tin layer 9 described later at a temperature of not less than 300°C, for example.

An outermost layer 7 is adapted to have a distance of not more than 1 µm from the outer surface 12 toward an inside of the covering layer 5, and includes at least Cu₄₁Sn₁₁. and/or Cu₁₀Sn₃. The outermost layer 7 may additionally include Cu₃Sn or the like. Further, the outermost layer 7 includes, e.g., more than 30 atomic % of copper, or preferably more than 75 atomic % of copper as the average composition thereof. The upper limit of the average composition of copper in the outermost layer 7 is 80 atomic % in general .

The aforementioned atomic ratio of copper to tin and the aforementioned alloy can be measured by field emission scanning electron microscopy analysis (FE-SEM) , transmission electron microscopy analysis (TEM), energy dispersive X-ray spectroscopy analysis (EDS), Auger electron spectroscopy analysis (AES), electron probe microanalysis (EPMA) or the like after preparing a sample for cross-sectional observation with FIB.

An adjacent layer 8 is adapted to have a distance of more than 1 µm and not more than 2 µm from the outer surface 12 toward an inside of the covering layer 5, and includes an alloy having an atomic ratio of copper to tin of, e.g., more than 9, or preferably more than 13. More specifically, the adjacent layer 8 includes an alloy such as Cu₉₄Snₙ (n = 2 to 25), or further specifically Cu₉₄Sn₆. The adjacent layer 8 includes, e.g., more than 90 atomic %, or preferably more than 92 atomic % of copper as the average composition thereof. The upper limit of the average composition of copper in the adjacent layer 8 is 99 atomic % in general.

The unshown terminal portions are formed on the insulating cover layer 6 to be exposed. An insulating material similar to that forming the aforementioned insulating base layer 3 is used to form the insulating cover layer 6. The thickness of the insulating cover layer 6 is in the range of, e.g., 2 to 10 µm, or preferably 3 to 6 µm.

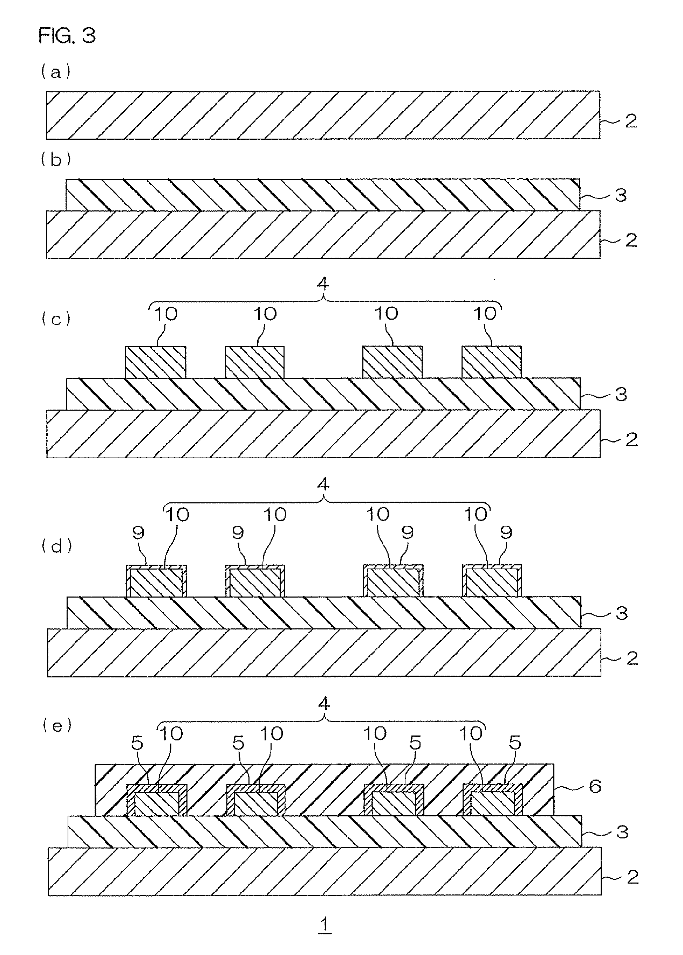

A producing method of the wired circuit board 1 is now described with reference to FIG. 3.

First, as shown in FIG. 3 (a) , the metal supporting board 2 is prepared according to this method.

Then, as shown in FIG. 3 (b) , the insulating base layer 3 is formed according to this method.

In order to form the insulating base layer 3, a varnish of an insulating material, such as a varnish of synthetic resin, for example, used to form the insulating base layer 3 is coated, dried and cured as necessary. More specifically, a varnish of photosensitive resin, preferably a varnish of photosensitive polyamic acid resin is coated, dried, thereafter exposed to light and developed, and thereafter cured for forming the insulating base layer 3 in the aforementioned pattern.

Then, as shown in FIG. 3(c), the conductive pattern 4 is formed on the insulating base layer 3 in the aforementioned wired circuit pattern according to this method.

The conductive pattern 4 is formed by, e.g., a patterning method such as an additive method or a subtractive method. Preferably, the conductive pattern 4 is formed by the additive method.

In the additive method, an unshown seed film is first formed on the entire surface of the insulating base layer 3. Examples of a material used to form the seed film include metallic materials such as copper and chromium or an alloy thereof. This seed film is formed by sputtering, electrolytic plating or electroless plating. Then, a dry film resist is provided on the surface of the seed film and exposed to light and developed to form an unshown plating resist in a pattern reverse to the wired circuit pattern. Then, the conductive pattern 4 is formed on the surface of the seed film exposed through the plating resist by plating, and the plating resist and the portion of the seed film where the plating resist is formed are removed by etching or the like. The conductive pattern 4 is preferably formed by electrolytic copper plating.

Then, as shown in FIG. 3(d), the tin layer 9 is formed on the surface of the conductive pattern 4 according to this method.

In order to form the tin layer 9, tin plating, for example, or preferably electroless tin plating is used. Since the conductive pattern 4 is made of copper, the tin layer 9 is formed by substitution between copper and tin in this electroless tin plating.

The thickness of the tin layer 9 is in the range of, e.g., 0.05 to 2.8 µm, or preferably 0.15 to 0.8 µm. If the thickness of the tin layer 9 is less than the aforementioned range, it may not be possible to prevent ion migration of copper in the conductive pattern 4. If the thickness of the tin layer 9 is in excess of the aforementioned range, on the other hand, whiskers may be formed.

Then, as shown in FIG. 3(e), the insulating cover layer 6 as well as the covering layer 5 are formed according to this method.

In order to form the insulating cover layer 6, a varnish of an insulating material, such as a varnish of synthetic resin, for example, used to form the insulating cover layer 6 is coated, dried and cured as necessary. More specifically, a varnish of photosensitive synthetic resin, preferably a varnish of photosensitive polyamic acid resin is coated, dried, exposed to light and developed, and thereafter cured for forming the insulating cover layer 6 in the aforementioned pattern.

The covering layer 5 is formed simultaneously with formation of the insulating cover layer 6 by heating in the process of drying or curing for forming the insulating cover layer 6.

The heating temperature for drying or curing the varnish is set to the range of, e.g., not less than 300°C, preferably not less than 340°C, or more preferably not less than 360°C and not more than 410°C in general, and the heating time is set to the range of, e.g., 60 to 300 minutes, or preferably 80 to 300 minutes. The varnish can also be heated under an oxygen-containing atmosphere such as the atmosphere or an inert gas atmosphere of nitrogen or the like, preferably under the inert gas atmosphere.

If the heating temperature is below the aforementioned range, the atomic ratio of copper to tin in the outer surface 12 of the covering layer 5 cannot exceed 3, whereby it may not be possible to prevent ion migration of copper forming the conductive pattern 4 or discoloration of the conductive pattern 4.

Thus, tin is diffused with respect to copper forming the conductive pattern 4 while copper forming the conductive pattern 4 is diffused with respect to tin, thereby forming the covering layer 5 made of an alloy of copper and tin.

In this diffusion of tin, the part of tin forming the tin layer 9 formed on the upper surface of the conductive pattern 4 is diffused downward while the part of tin forming the tin layer 9 formed on the side surfaces of the conductive pattern 4 is diffused inward, whereby the covering layer 5 is formed with a thickness larger than that of the tin layer 9 before heating. Due to this diffusion of tin, tin forming the tin layer 9 is substituted by the alloy of copper and tin, and the tin layer 9 substantially disappears.

According to this method, the covering layer 5 formed on the upper surfaces of the unshown terminal portions of the conductive pattern 4 is removed by etching or the like, and the metal supporting board 2 is trimmed into a desired shape, thereby obtaining the wired circuit board 1.

According to the wired circuit board 1 obtained in this manner, ion migration of copper forming the conductive pattern 4 can be effectively prevented. Therefore, the wires 10 forming the conductive pattern 4 can be effectively prevented from a short circuit resulting from usage over a long period, and connectional reliability can be improved.

According to this wired circuit board 1, further, discoloration (corrosion) of the conductive pattern 4 can be effectively prevented also in usage under the circumstances of high temperature and humidity, whereby connectivity to a magnetic head or a read/write board and connectional durability can be improved in the terminal portions. Further, in the wires 10, the insulating cover layer 6 can be prevented from stripping off due to corrosion of the wires 10.

The covering layer 5 is formed simultaneously with formation of the insulating cove layer 6 in the above description of the step shown in FIG. 3(e). Alternatively, the covering layer 5 made of the alloy of copper and tin can be formed by previously forming a film of synthetic resin in the aforementioned pattern, adhering this film onto the insulating base layer 3 including the tin layer 9 to form the insulating cover layer 6 and thereafter heating the wired circuit board 1 thereby diffusing tin from the tin layer 9 into copper forming the conductive pattern 4.

Preferably, the covering layer 5 made of the alloy of copper and tin is formed simultaneously with formation of the insulating cover layer 6. Thus, the drying or curing in formation of the insulating cover layer 6 and diffusing tin with respect to copper in formation of the covering layer 5 can be simultaneously carried out, thereby simplifying the producing steps.

While the wired circuit board according to the present invention is illustrated and described as the suspension board with circuit including the metal supporting board 2 in the above description, the wired circuit board according to the present invention is also widely applicable to other wired circuit board such as a flexible wired circuit board not including the metal supporting board 2, for example.

### [Example]

The present invention is described more specifically by showing the examples and the comparative examples herein below. However, the present invention is by no means limited to the examples and the comparative examples.

### EXAMPLE 1

First, a metal supporting board of stainless steel having a thickness of 25 µm was prepared (see FIG. 3(a)). Then, a varnish of photosensitive polyamic acid resin was applied to the entire surface of the metal supporting board, and heated and dried at 90°C for 15 minutes. Then, the varnish was exposed to light and developed, and thereafter heated and cured (imidized) at 370°C for 120 minutes under a reduced pressure to form an insulating base layer having a thickness of 10 µm (see FIG. 3(b)).

Then, a seed film was formed by successively forming a thin chromium film having a thickness of 50 nm and a thin copper film having a thickness of 100 nm by sputtering. Then, a plating resist having a pattern reverse to the conductive pattern was formed on the upper surface of the seed film, and a conductive pattern made of copper having a thickness of 10 µm was formed by electrolytic copper plating (see FIG. 3(c)). The width of each wire was 20 µm, and the interval between each of the wires was 20 µm.

Then, a tin layer having a thickness of 0.45 µm was formed on the surface of the conductive pattern by electroless tin plating (see FIG. 3(d)).

Then, a varnish of photosensitive polyamic acid resin was applied to the entire upper surface of the insulating base layer including the tin layer, and heated and dried at 90°C for 15 minutes. Then, the varnish was exposed to light and developed, and thereafter heated and cured (imidized) at 400°C for 120 minutes under a reduced pressure to form a covering layer made of an alloy of copper and tin (see FIG. 3(e)). The thickness of the covering layer was 2.0 µm. The thickness of the covering layer was measured with an FE-SEM and AES (Model 1680 produced by Hitachi, Ltd., applied voltage: 15 kV).

Then, the covering layer on the upper surfaces of terminal portions was removed by etching, thereby obtaining a suspension board with circuit (see FIG. 1).

### COMPARATIVE EXAMPLE 1

A suspension board with circuit was subsequently obtained by forming a covering layer in the same manner as in EXAMPLE 1, except that the heating temperature in curing for forming the insulating cover layer was changed from 400°C to 120°C. The thickness of the covering layer was 2.0 µm.

### COMPARATIVE EXAMPLE 2

A suspension board with circuit was subsequently obtained by forming a covering layer in the same manner as in EXAMPLE 1, except that the heating temperature in curing for forming the insulating cover layer was changed from 400°C to 180°C. The thickness of the covering layer was 2.0 µm.

### (Evaluation)

### (1) Measurement of Atomic Ratio of Copper

In the suspension boards with circuit obtained according to EXAMPLE 1 and COMPARATIVE EXAMPLES 1 and 2, the atomic ratio of Cu/Sn, the average composition (atomic %) of Cu and the type of the alloy were measured as to the outer surface, the outermost layer and the adjacent layer of the covering layer with an FE-SEM and ES, and TEM and ENDS (EDS system by Inca, applied voltage: 200 kV) respectively.

Table 1 shows the results. However, Table 1 shows only the atomic ratio of Cu/Sn as to the outer surface.

### (2) Evaluation of Ion Migration

In the suspension boards with circuit obtained according to EXAMPLE 1 and COMPARATIVE EXAMPLES 1 and 2, a voltage of 10 V was applied to the conductive pattern for obtaining a Weibull chart in the time in which the current reached 20 mA, and this Weibull chart was analyzed. In this analysis, ion migration was evaluated by the time in which the cumulative percent defective in the Weibull chart reached 0.1%. Table 1 also shows the results. Ion migration is hardly caused, when it takes long until the cumulative rejection rate in the Weibull chart reaches 0.1 %, or which shows high connectional reliability.

### (3) Evaluation of Discoloration

The suspension boards with circuit obtained according to EXAMPLE 1 and COMPARATIVE EXAMPLES 1 and 2 was subjected to an acceleration test under the circumstances of high temperature and humidity. In the acceleration test, the suspension board with circuit was introduced into a pressure cooker tester (PCT tester produced by ESPEC Corp.) under conditions of a temperature of 120°C, humidity of 100 % and a pressure of 0.172 MPa according to IEC68-2-66 (environmental testing procedure), and discoloration of the conductive pattern after 29 hours was con firmed with an optical microscope. Table 1 also shows the results.

**[Table 1]**

| Example/Comparative Example | | | Example 1 | Comparative Example 1 | Comparative Example 2 |
|---|---|---|---|---|---|
| Covering Layer | Heating Temperature in Formation of Covering Layer (°C) | | 400 | 120 | 180 |
| | Outer Surface | Cu/Sn (Atomic Ratio) | 3.3 | 1.2 | 3 |
| | Outermost Layer | Cu/Sn (Atomic Ratio) | 3.3 | 1.2 | 3 |
| | | Cu (Atomic%) | 75 | 20 | 75 |
| | | Type of Alloy | Cu₄₁Sn₁₁ Cu₁₀Sn₃ Cu₃Sn | Cu₁₁Sn₉ | Cu₃Sn |
| | Adjacent Layer | Cu/Sn (Atomic Ratio) | 9.3 | 3 | 3 |
| | | Cu (Atomic%) | 92 | 78 | 87 |
| | | Type of Alloy | Cu₉₄Sn₆ Cu₃Sn | Cu₃Sn | Cu₃Sn |
| Evaluation | Ion Migration | Time ^{*1} (sec. ) | 25 | 2 | 2.5 |
| | Discoloration | Conductive Pattern | Not Discolored | Discolored | Discolored |

| | | | | | |
|---|---|---|---|---|---|
| *1. The time until the cumulative percent defective in the Weibull chart reached 0.1% | | | | | |

## Claims

1. A wired circuit board comprising:
an insulating layer;
a conductive pattern made of copper formed on the insulating layer; and
a covering layer made of an alloy of copper and tin to cover the conductive pattern, wherein
an existing ratio of tin in the covering layer increases in accordance with a distance from an inner surface adjacent to the conductive pattern toward an outer surface being not adjacent to the conductive pattern, and
an atomic ratio of copper to tin in the outer surface of the covering layer is more than 3.

2. The wired circuit board according to Claim 1, wherein an outermost layer having a distance of not more than 1 µm from the outer surface toward an inside of the covering layer includes Cu₄₁Sn₁₁ and/or Cu₁₀Sn₃.

3. The wired circuit board according to Claim 1, wherein an adjacent layer having a distance of more than 1 µm and not more than 2 µm from the outer surface toward an inside of the covering layer includes an alloy having an atomic ratio of copper to tin of more than 9.

4. The wired circuit board according to Claim 1, wherein the covering layer is obtained by heating at a temperature of not less than 300°C.

5. A producing method of a wired circuit board, the method comprising the steps of:
preparing an insulating layer;
forming a conductive pattern made of copper on the insulating layer;
forming a tin layer to cover the conductive pattern; and
heating the conductive pattern and the tin layer at a temperature of not less than 300°C to form a covering layer made of an alloy of copper and tin.
